# EUROPÄISCHE PATENTSCHRIFT

(11) **EP 2 278 231 B1**
(45) Veröffentlichungstag und Bekanntmachung des Hinweises auf die Patenterteilung: **08.11.2017**
(21) Anmeldenummer: 10006404.7
(22) Anmeldetag: 21.06.2010
(51) Int. Cl.: F24F 3/044, H05K 7/20, F24F 11/00

(54) **Klimaanlage**
Air conditioning device
Installation de climatisation

(30) Priorität: 22.06.2009 DE 102009030114
(43) Veröffentlichungstag der Anmeldung: 26.01.2011
(73) Patentinhaber: Weiss Klimatechnik GmbH, 35447 Reiskirchen (DE)
(72) Erfinder: Andersen, Heiner, 85630 Grasbrunn (DE)
(74) Vertreter: Stoffregen, Hans-Herbert

(56) Entgegenhaltungen:
- EP-A2- 0 741 269
- WO-A2-2006/124240
- DE-C2- 10 048 877

## Beschreibung

Die Erfindung bezieht sich auf eine Anordnung einer Klimaanlage gemäß dem Oberbegriff des Patentanspruches 1.

Eine solche Anordnung einer Klimaanlage ist aus der DE 100 48 877 C2 bekannt. Dort ist ein Klimagerät zur Anordnung in einem Raum beschrieben, der einen Boden und einen darunterliegenden Hohlraum aufweist. Das Klimagerät erstreckt sich mit einem Gehäuse durch den Boden hindurch und enthält oberhalb des Bodens eine Kühleinrichtung in Form eines Wärmetauschers zum Abkühlen erwärmter Raumluft und eine unterhalb des Bodens angeordnete Ventilatoreinrichtung zum Abführen der abgekühlten Luft. Die Ventilatoreinrichtung enthält ein Ventilatorrad, daß so angeordnet ist, daß die abgekühlte Luft radial zur Ventilatorachse und im wesentlichen parallel zum Boden aus der Ventilatoreinrichtung austritt.
Durch die Zunahme elektrischer und elektronischer Geräte, insbesondere Computer, fallen in Büros, Serverräumen und Rechenzentren erhebliche Energiemengen an Abwärme an, die durch leistungsfähige Kühl- bzw. Klimageräte abgeführt werden muß, um die Computer vor Überhitzung zu schützen. Die verwendeten Klimageräte sollen eine möglichst hohe Kühlleistungsdichte, d.h. eine hohe Kühlleistung, bei möglichst kleiner Standfläche haben. Hierfür werden Wärmetauscher eingesetzt, die mit relativ hohen Vorlauftemperaturen arbeiten können, wobei Vorlauf-/Rücklauftemperaturverhältnisse von 10/15°C oder 16/22°C angestrebt werden.

Die EP 0 741 269 A2 verwendet zur Kühlung eines Raumes mit einem unterhalb des Bodens angeordneten Hohlraum ein Klimagerät mit Wärmetauscher und Ventilator, das oberhalb des Bodens angeordnet ist. Alle Geräte, also die zu kühlenden Geräte und das Klimagerät, haben dort eine Strömungsverbindung zu dem Hohlraum unterhalb des Bodens. Das Klimagerät mit Wärmetauscher und Ventilator ist innerhalb des zu kühlenden Raumes angeordnet, wobei ein Kälteerzeuger außerhalb des zu kühlenden Raumes angeordnet sein kann. Gleichwohl nimmt der in dem zu kühlenden Raum angeordnete Teil des Klimagerätes eine beträchtliche Stellfläche in Anspruch, die nicht für Geräte, wie z.B. Computer, nutzbar ist.

Ähnliche Einrichtungen mit Wärmetauscher und Ventilator sind auch aus der DE 10 2007 007 928 A1, DE 20 2007 002 361 U1 und DE 20 2008 010 063 U1 bekannt.

Aufgabe der Erfindung ist es, die Klimaanlage der eingangs genannten Art dahingehend zu verbessern, daß eine hohe Kühlleistung bei geringem Bedarf an Stellfläche in dem zu kühlenden Raum erreicht wird. Weiter soll die Klimaanlage flexibel an unterschiedliche Räume anpaßbar sein.

Diese Aufgabe wird durch die im Patentanspruch 1 angegebenen Merkmale gelöst. Vorteilhafte Ausgestaltungen und Weiterbildungen der Erfindung sind den abhängigen Ansprüchen zu entnehmen.

Die Grundidee der Erfindung besteht darin, den Wärmetauscher gehäuselos auszugestalten und ihn so großflächig auszubilden, daß er einen wesentlichen Anteil der Fläche einer Raumbegrenzung bildet. Der Wärmetauscher und die Ventilatoreinrichtung sind dabei voneinander getrennt und können unabhängig voneinander plaziert werden, so daß eine große Flexibilität hinsichtlich der Anordnung der Komponenten der Klimaanlage bezüglich des Raumes gegeben ist. Der Wärmetauscher wird parallel in engem Abstand zu mindestens einer Wand des Raumes aufgestellt. Damit ergibt sich zwischen der entsprechenden Wand des Raumes und dem Wärmetauscher ein Hohlraum, der mit dem unterhalb des Bodens angeordneten Hohlraum in Strömungsverbindung steht.

Bei einem Ausführungsbeispiel der Erfindung entspricht die Fläche des Wärmetauschers der Fläche der benachbarten Wand des Raumes, so daß der Wärmetauscher praktisch eine vollständige Raumbegrenzung bildet. Durch diese großflächige Ausgestaltung des Wärmetauschers wird eine hohe Kühlleistung erreicht. Auch entstehen durch den großflächigen Wärmetauscher wesentlich reduzierte Druckverluste hinsichtlich der Luftströmung durch den Wärmetauscher. Man kann daher kleinere Lüfter mit geringerem Energieverbrauch verwenden, was auch die Geräuschentwicklung reduziert. Andererseits kann man mit herkömmlich groß dimensionierten Lüftern eine höhere Kühlleistung erreichen.

Der gehäuselose Wärmetauscher kann auch "über Eck" angeordnet werden, d.h. parallel zu zwei oder mehr Wänden des Raumes angeordnet sein. Auch kann der Wärmetauscher mit entsprechender Raumteilerwand als "Insellösung" im Raum angeordnet sein.

Je nach zu erbringender Kühlleistung kann der Wärmetauscher auch nur einen Teil einer Wand des Raumes abdecken.

Im folgenden wird die Erfindung anhand von Ausführungsbeispielen im Zusammenhang mit der Zeichnung ausführlicher erläutert. Es zeigt:
- Fig. 1: eine perspektivische Prinzipdarstellung eines Raumes mit Klimaanlage nach der Erfindung;
- Fig. 2: ein Ausführungsbeispiel der Erfindung, bei der der Wärmetauscher über Eck angeordnet ist;
- Fig. 3: ein Ausführungsbeispiel der Erfindung, bei der der Wärmetauscher nur einen Teil einer Wand des Raumes abdeckt;
- Fig. 4: eine Klimaanlage nach der Erfindung, bei der der Wärmetauscher in der Mitte des Raumes angeordnet ist.

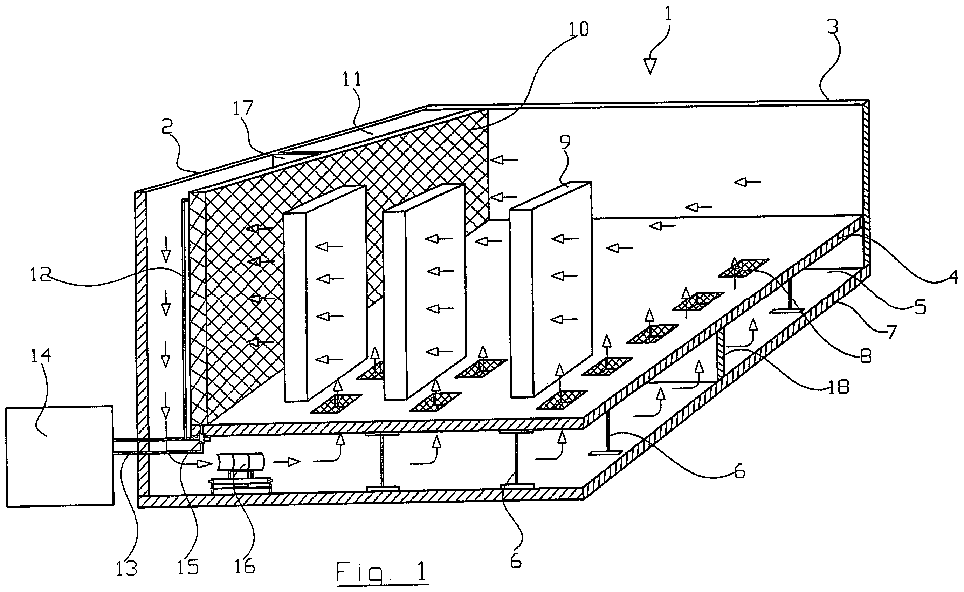

Fig. 1 zeigt in schematischer perspektivischer geschnittener Draufsicht einen zu klimatisierenden Raum 1, von dem eine erste Seitenwand 2 und eine zweite Seitenwand 3 zu sehen sind. Der Raum hat einen Boden 4, unterhalb dessen sich ein Hohlraum 5 befindet. Der Boden 4 ist über mehrere Trägerelemente 6 gegenüber einer unteren Wand 7 abgestützt. Der Boden 4 hat eine Vielzahl von Öffnungen 8, über die der Raum 1 mit dem Hohlraum 5 in Strömungsverbindung für eine Luftströmung steht, die durch Pfeile angedeutet ist. Die Öffnungen 8 sind durch Gitterroste abgedeckt.

In dem Raum befinden sich zu kühlende Gegenstände 9, die beispielsweise Computer oder Schaltschränke sind, die Wärme entwickeln, welche abzuführen ist.

Parallel zur ersten Seitenwand 2 ist ein Wärmetauscher 10 in einem Abstand zur ersten Seitenwand 2 angeordnet, so daß sich zwischen der ersten Seitenwand 2 und der dem Raum 1 abgewandten Rückseite des Wärmetauschers 10 ein zweiter Hohlraum 11 bildet.

Der Wärmetauscher 10 ist hier über Rohrleitungen 12 und 13 mit einer Kühleinrichtung 14 verbunden, die sich außerhalb des Raumes 1 befindet. Über diese Rohrleitungen wird ein Kühlmedium, wie z.B. Wasser, zu dem Wärmetauscher 10 geleitet und von diesem abgeführt. Über ein Regelventil 15 kann der Durchfluß des Kühlmediums durch den Wärmetauscher 10 geregelt werden, was unter Steuerung eines nicht dargestellten, im Raum 1 befindlichen Thermostat erfolgen kann.

Im ersten Hohlraum 5 ist eine Ventilatoreinrichtung 16 angeordnet. Vorzugsweise handelt es sich um einen gehäuselosen Radialventilator, der eine radial zu seiner Drehachse gerichtete Luftströmung erzeugt. Die Ventilatoreinrichtung 16 kann nach einem nicht dargestellten Ausführungsbeispiel auch in dem zweiten Hohlraum 11, also oberhalb des Bodens 4 angeordnet sein.

Der Wärmetauscher 10 deckt im Ausführungsbeispiel der Fig. 1 im Wesentlichen die gesamte erste Seitenwand 2 ab und bildet damit eine Begrenzungswand des nutzbaren Raumes 1. Aufgrund seiner großen Fläche erbringt er eine große Kühlleistung und kann damit mit einer geringen Temperaturdifferenz zwischen Vorlauf- und Rücklauftemperatur des Kühlmediums betrieben werden.

Durch die Ventilatoreinrichtung 16 wird im ersten Hohlraum 5 ein Überdruck erzeugt, der eine Luftströmung entlang der Pfeile bewirkt. Die Strömung verläuft im ersten Hohlraum im Wesentlichen parallel und tritt vertikal aus den Öffnungen 8 aus dem Boden 4 in den Raum 1 aus. Dort läuft sie zurück in Richtung zu dem Wärmetauscher 10 und kühlt die Gegenstände 9, die üblicherweise bei Computern oder Schaltschränken noch eigene Lüfter haben, die die Luft durch das Innere der Gegenstände 9 leiten. Von dort gelangt die Strömung zu dem Wärmetauscher 10 und durch diesen hindurch in den zweiten Hohlraum 11, wo sie im Wesentlichen vertikal nach unten zu der Ventilatoreinrichtung 16 strömt.

Der gehäuselose Wärmetauscher 10 ist hinsichtlich seiner Anordnung bzw. Lage unabhängig von der Ventilatoreinrichtung 16, so daß sich je nach baulichen Gegebenheiten des Raumes eine hohe Flexibilität ergibt. Der Wärmetauscher und die Ventilatoreinrichtung können damit hinsichtlich ihrer Größe und Menge jederzeit den Bedürfnissen angepaßt oder auch später nachgerüstet werden.

Selbstverständlich können im Hohlraum 5 oder im Hohlraum 11 auch mehrere Ventilatoreinrichtungen angeordnet sein, um eine ausreichende und gleichmäßige Strömung zu erzeugen. Dabei können in den beiden Hohlräumen 5 und 11 auch Leit- oder Trennwände 17 und 18 angeordnet sein, die getrennte Strömungswege bilden und denen jeweils eine eigene Ventilatoreinrichtung zugeordnet ist.

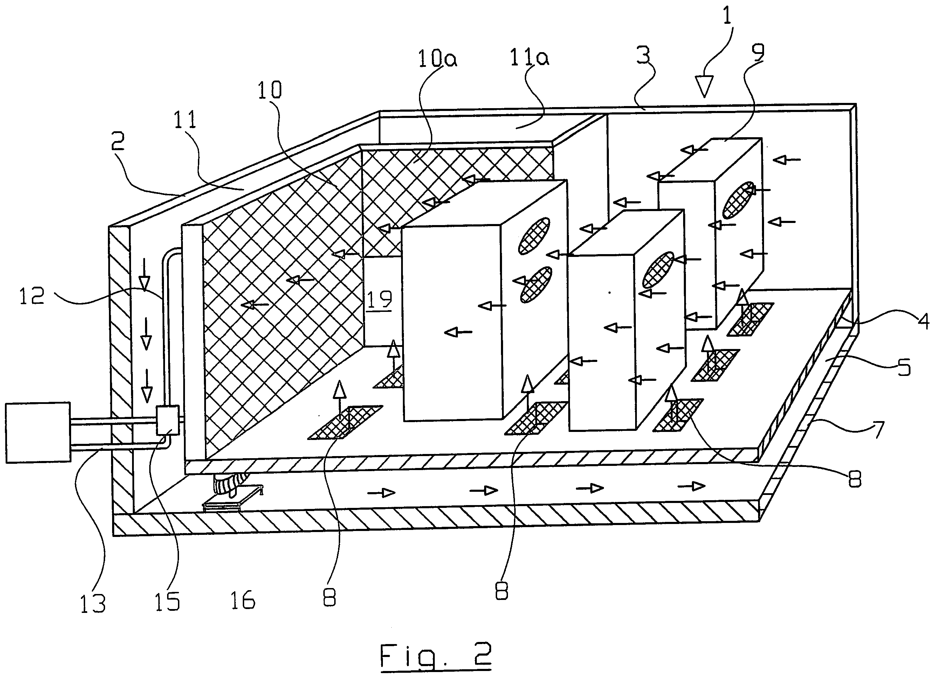

Das Ausführungsbeispiel der Fig. 2 unterscheidet sich von dem der Fig. 1 dadurch, daß der Wärmetauscher 10 "über Eck" angeordnet ist, d.h. mit einem Element 10 parallel zur ersten Seitenwand 2 und mit einem anderen Element 10a parallel zur zweiten Seitenwand 3 angeordnet ist, wobei zusätzlich das parallel zur zweiten Seitenwand 3 liegende Element 10a nur im oberen Bereich der zweiten Seitenwand 3 angeordnet ist, während im unteren Bereich eine abdichtende Platte 19 angeordnet ist.

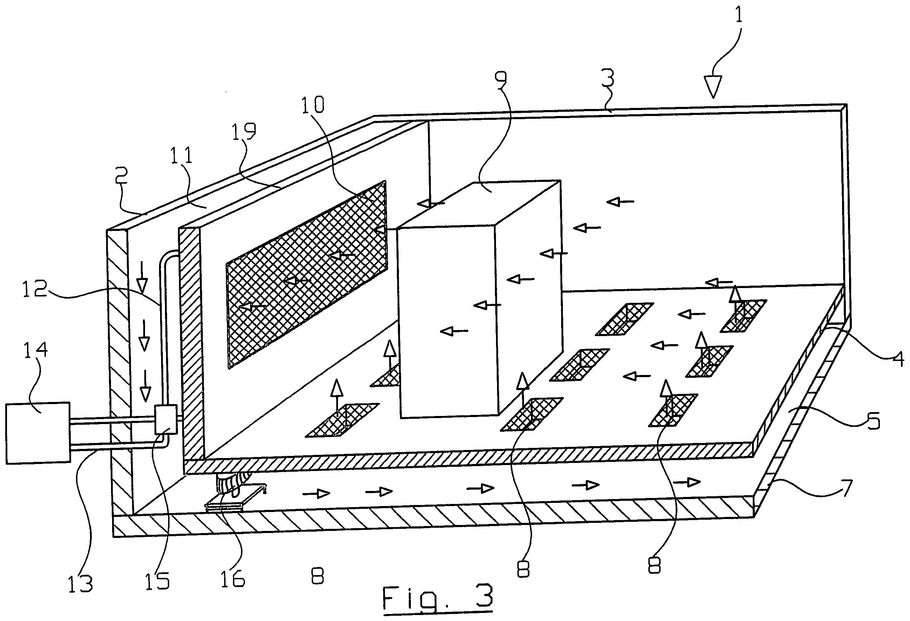

Im Ausführungsbeispiel der Fig. 3 ist die von dem Wärmetauscher 10 abgedeckte Fläche kleiner als die Fläche der ersten Seitenwand 2, wobei der Wärmetauscher 10 dann in eine abdichtende Platte 19 eingesetzt ist, die ihrerseits parallel und im Abstand zur ersten Seitenwand 2 liegt und damit zusammen mit dem Wärmetauscher 10 und der Seitenwand 2 den zweiten Hohlraum 11 bildet. Auch hier sind aber der Wärmetauscher 10 und die Ventilatoreinrichtung 16 unabhängig voneinander und der Wärmetauscher 10 ist gehäuselos. Generell ist aber festzuhalten, daß die hier von dem Wärmetauscher 10 abgedeckte Fläche etwa 50% der Fläche der Seitenwand 2 beträgt.

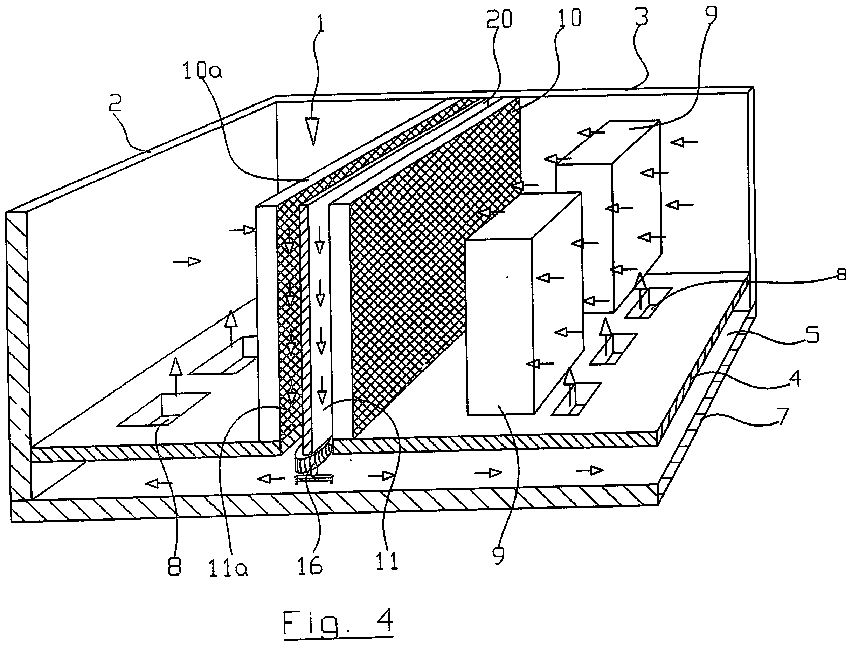

Fig. 4 zeigt ein Ausführungsbeispiel, bei dem Wärmetauscher 10 und 10a zusammen mit einer Trennwand 20 als Raumteiler verwendet werden. Hierbei werden zwei parallele durch die Trennwand 20 getrennte Hohlräume 11 und 11a gebildet, die jeweils mit dem ersten Hohlraum 5 in Strömungsverbindung stehen. Eine gemeinsame Ventilatoreinrichtung 16 ist unterhalb der Trennwand 20 angeordnet und bläst die vertikal von oben aus den Hohlräumen 11 und 11a kommende Luft radial zu ihrer vertikalen Drehachse nach beiden Seiten.

Nicht dargestellte Rohrleitungen zu den beiden Wärmetauschern 10 und 10a werden hier zweckmäßiger Weise im unteren Hohlraum 5 nach außen zu einem ebenfalls nicht dargestellten Kühlaggregat (vgl. 14 in Fig. 1) geführt.

Auch bei dieser Variante können die Wärmetauscher 10 und 10a sowohl die gesamte Fläche einer der Seitenwände wie z.B. der Seitenwand 2 abdecken oder sie können auch entsprechend der Variante der Fig. 3 nur einen Teil der entsprechenden Wand abdecken.

Selbstverständlich können auch hier in den Hohlräumen 5, 11 und 11a Trennwände entsprechend den Trennwänden 17 und 18 der Fig. 1 angeordnet sein, wobei dann auch mehrere Ventilatoreinrichtungen einzusetzen sind.

Zusammengefaßt schafft die Erfindung also eine hochwirksame und flexibel den baulichen Gegebenheiten eines Raumes anpaßbare Klimaanlage mit einfachem Aufbau. Aufgrund der großen wirksamen Fläche der Wärmetauscher kann mit geringen Temperaturdifferenzen zwischen Vorlauf- und Rücklauftemperatur des Kühlmediums für die Wärmetauscher gearbeitet werden. Auch können Ventilatoreinrichtungen mit niedrigem Energiebedarf eingesetzt werden und die Strömungsgeschwindigkeit der im Raum bewegten Luft kann gering gehalten werden, so daß diese Klimaanlage auch in Räumen eingesetzt werden kann, in denen Personen arbeiten, ohne daß diese durch "Zugluft" beeinträchtigt werden.

Als Kühleinrichtung 14 (Fig. 1) kommen alle bekannten Kühleinrichtungen in Frage, wie z.B. ein Wärmetauscher, der im Freien aufgestellt ist und die dortige Umgebungsluft zur Kühlung des aus dem Wärmetauscher 10 des Raumes 1 kommende Medium wie Wasser oder sonstige Kühlflüssigkeit abkühlt. Eine Möglichkeit besteht darin, einen entsprechenden Wärmetauscher in einen Brunnen, einen Fluß oder ein sonstiges Gewässer zu setzen. Denkbar ist auch ein Wärmetauscher, der mit einer Flüssigkeit, wie Wasser besprüht wird und durch Verdunstungskälte Wärme abführt. Je nach Umweltbedingungen können auch Kompressor-Kühlaggregate oder Kühlaggregate mit Peltierelementen verwendet werden.

Abschließend sei darauf hingewiesen, daß die in den einzelnen Ausführungsbeispielen beschriebenen Merkmale auch miteinander kombiniert werden können. Nur als Beispiel sei erwähnt, daß die in Fig. 4 gezeigte "Insellösung" auch mit der in Fig. 2 gezeigten Ecklösung kombiniert werden kann oder die in Fig. 1 beschriebene Lösung mit den Trennwänden 17 und 18 auch bei den Ausführungsbeispielen der Fig. 2, 3 und 4 angewandt werden kann.

## Patentansprüche

1. Anordnung einer klimaanlage in einem Raum, der einen Boden (4) mit Öffnungen (8) und einen darunter liegenden Hohlraum (5) aufweist, mit einem Oberhalb des Bodens (4) angeordneten Wärmetauscher (10) und eine Ventilatoreinrichtung (16), die vom Wärmetauscher abfließende Kühlluft durch den Hohlraum (5) zu den Öffnungen (8) fördert, **dadurch gekennzeichnet, daß** der Wärmetauscher (10) gehäuselos ist und mindestens einen Teilbereich einer Begrenzungswand des Raumes (1) bildet.

2. Anordnung nach Anspruch 1, **dadurch gekennzeichnet, daß** der Wärmetauscher (10) unter Bildung eines zweiten Hohlraumes (11) parallel zu einer Wand (2) des Raumes (1) angeordnet ist und daß der zweite Hohlraum (11) mit dem unterhalb des Bodens (4) angeordneten Hohlraum (5) in Strömungsverbindung steht.

3. Anordnung nach Anspruch 2, **dadurch gekennzeichnet, daß** die Ventilatoreinrichtung (16) im unterhalb des Bodens (4) angeordneten Hohlraum (5) angeordnet ist.

4. Anordnung nach Anspruch 2, **dadurch gekennzeichnet, daß** die Ventilatoreinrichtung (16) im zweiten Hohlraum (11) angeordnet ist.

5. Anordnung nach einem der Ansprüche 1 oder 4, **dadurch gekennzeichnet, daß** der Wärmetauscher (10) und die Ventilatoreinrichtung (16) als separate Bauteile unabhängig voneinander plazierbar sind.

6. Anordnung nach einem der Ansprüche 1 bis 5, **dadurch gekennzeichnet, daß** der Wärmetauscher (10) mindestens die Hälfte der Fläche der benachbarten Wand (2) des Raumes (1) abdeckt.

7. Anordnung nach einem der Ansprüche 1 bis 6, **dadurch gekennzeichnet, daß** der Wärmetauscher (10, 10a) gegenüberliegend zu zwei aneinander angrenzenden Wänden (2, 3) des Raumes (1) unter Bildung von zwei Hohlräumen (11, 11a) angeordnet ist.

8. Anordnung nach Anspruch 1, **dadurch gekennzeichnet, daß** der Wärmetauscher (10, 10a) als Raumteiler im Raum (1) angeordnet ist.

9. Anordnung nach Anspruch 8, **dadurch gekennzeichnet, daß** zwei Wärmetauscher (10, 10a) und eine zwischen diesen angeordnete Trennwand (20) unter Bildung von zwei Hohlräumen (11, 11a) im Raum angeordnet sind, wobei beide Hohlräume (11, 11a) mit dem unterhalb des Bodens (4a) angeordneten Hohlraum (5) in Strömungsverbindung stehen.

10. Anordnung nach einem der Ansprüche 1 bis 9, **dadurch gekennzeichnet, daß** der bzw. die Wärmetauscher (10; 10a) senkrecht im Raum (1) angeordnet sind.

11. Anordnung nach einem der Ansprüche 1 bis 10, **dadurch gekennzeichnet, daß** der unterhalb des Bodens (4) angeordnete Hohlraum (5) durch mindestens eine Trennwand (18) in mindestens zwei Teilhohlräume unterteilt ist, daß der zwischen der Wand (2) des Raumes (1) und dem Wärmetauscher (10) angeordnete Hohlraum (11) ebenfalls durch eine Trennwand (17) in mindestens zwei Teilhohlräume unterteilt ist und daß die jeweiligen Teilhohlräume unterhalb des Bodens (4) mit den genannten Teilhohlräumen zwischen der Wand (2) und dem Wärmetauscher (10) jeweils miteinander in Strömungsverbindung stehen.

## Claims

1. Arrangement of an air-conditioning system in a room having a floor (4) with openings (8) and a cavity (5) underneath it, with a heat exchanger (10) arranged above said floor (4), and a fan device (16) which conveys cooling air flowing from said heat exchanger through said cavity (5) to said openings (8), **wherein**
said heat exchanger (10) is housing-free and forms at least one partial area of a limiting wall of said room (1).

2. Arrangement according to claim 1, wherein
**wherein**
the heat exchanger (10) is arranged parallel to a wall (2) of the room (1), forming a second cavity (11), and said second cavity (11) is in a flow connection to the cavity (5) arranged below the floor (4).

3. Arrangement according to claim 2,
**wherein**
the fan device (16) is arranged in the cavity (5) arranged below the floor (4).

4. Arrangement according to claim 2,
**wherein**
the fan device (16) is arranged in the second cavity (11).

5. Arrangement according to one of claims 1 or 4,
**wherein**
the heat exchanger (10) and the fan device (16) are positionable independently of one another as separate components.

6. Arrangement according to one of claims 1 to 5,
**wherein**
the heat exchanger (10) covers at least half of the surface of the adjacent wall (2) of the room (1).

7. Arrangement according to one of claims 1 to 6,
**wherein**
the heat exchanger (10, 10a) is arranged opposite to two adjacent walls (2, 3) of the room (1), forming two cavities (11, 11a),

8. Arrangement according to claim 1,
**wherein**
the heat exchanger (10, 10a) is arranged in the room (1) as a room divider.

9. Arrangement according to claim 8,
**wherein**
two heat exchangers (10, 10a) and a partition (20) arranged between them, forming two cavities (11, 11a), are arranged in the room, both said cavities (11, 11a) being in a flow connection to the cavity (5) arranged below the floor (4a).

10. Air-conditioning system according to one of claims 1 to 9,
**wherein**
the heat exchanger(s) (10, 10a) is (are) arranged vertically in the room (1).

11. Arrangement according to one of claims 1 to 10,
**wherein**
the cavity (5) arranged below the floor (4) is divided by at least one partition (18) into at least two partial cavities, the cavity (11) arranged between the wall (2) of the room (1) and the heat exchanger (10) is also divided by a partition (17) into at least two partial cavities, and the respective partial cavities below the floor (4) are each in a flow connection to said partial cavities between said wall (2) and said heat exchanger (10).

## Revendications

1. Disposition d'une installation de climatisation dans un local présentant un sol (4) avec des ouvertures (8) et une cavité (5) située en dessous, avec un échangeur thermique (10) disposé au-dessus du sol (4) et un dispositif de ventilation (16) qui achemine l'air de refroidissement provenant de l'échangeur thermique à travers ladite cavité (5) jusqu'auxdites ouvertures (8),
**caractérisé en ce**
**que** ledit échangeur thermique (10) est sans boîtier et forme au moins une partie d'une cloison de séparation du local (1).

2. Disposition selon la revendication 1,
**caractérisée en ce**
**que** l'échangeur thermique (10) est disposé parallèlement à une cloison (2) du local (1) en formant une seconde cavité (11) et que ladite seconde cavité (11) est en connexion fluidique avec la cavité (5) située en dessous du sol (4).

3. Disposition selon la revendication 2,
**caractérisée en ce**
**que** le dispositif de ventilation (16) est disposé dans la cavité (5) située en dessous du sol (4).

4. Disposition selon la revendication 2,
**caractérisée en ce**
**que** le dispositif de ventilation (16) est disposé dans la seconde cavité (11).

5. Disposition selon une des revendications 1 ou 4,
**caractérisée en ce**
**que** l'échangeur thermique (10) et le dispositif de ventilation (16) peuvent être placés comme composants séparés, indépendamment l'un de l'autre.

6. Disposition selon une des revendications 1 à 5,
**caractérisée en ce**
**que** l'échangeur thermique (10) couvre au moins la moitié de la surface de la cloison adjacente (2) du local (1).

7. Disposition selon une des revendications 1 à 6,
**caractérisée en ce**
**que** l'échangeur thermique (10, 10a) est disposé en face de deux cloisons contiguës (2, 3) du local (1) en formant deux cavités (11, 11a).

8. Disposition selon la revendication 1,
**caractérisée en ce**
**que** l'échangeur thermique (10, 10a) est disposé comme panneau de séparation dans le local (1).

9. Disposition selon la revendication 8,
**caractérisée en ce**
**que** deux échangeurs thermiques (10, 10a) et une cloison de séparation (20) disposée entre ceux-ci en formant deux cavités (11, 11a) sont disposés dans le local, sachant que lesdites deux cavités (11, 11a) sont en connexion fluidique avec la cavité (5) située en dessous du sol (4a).

10. Installation de climatisation selon une des revendications 1 à 9,
**caractérisée en ce**
**que** l'échangeur thermique ou les échangeurs thermiques (10, 10a) sont disposés à la verticale dans le local (1).

11. Disposition selon une des revendications 1 à 10,
**caractérisée en ce**
**que** la cavité (5) située en dessous du sol (4) est divisée en au moins deux cavités partielles par au moins une cloison de séparation (18), que la cavité (11) se trouvant entre la cloison (2) du local (1) et l'échangeur thermique (10) est divisée également en au moins deux cavités partielles par une cloison de séparation (17), et que les cavités partielles en dessous du sol (4) sont chacune en connexion fluidique avec lesdites cavités partielles situées entre la cloison (2) et l'échangeur thermique (10).
